(19) **Europäisches Patentamt**
**European Patent Office**
**Office européen des brevets**

(11) **EP 3 190 095 B1**

(12) **FASCICULE DE BREVET EUROPEEN**

(45) Date de publication et mention de la délivrance du brevet:
**02.08.2023 Bulletin 2023/31**

(21) Numéro de dépôt: **17150565.4**

(22) Date de dépôt: **06.01.2017**

(51) Classification Internationale des Brevets (IPC):
**C03C 3/06** (2006.01)   **C03C 3/083** (2006.01)
**C03C 3/085** (2006.01)   **C03C 3/087** (2006.01)
**C03C 3/091** (2006.01)   **G04B 17/22** (2006.01)
**G04B 39/02** (2006.01)   **H03H 9/24** (2006.01)

(52) Classification Coopérative des Brevets (CPC):
**C03C 3/06; C03C 3/083; C03C 3/085; C03C 3/087; C03C 3/091; G04B 17/227;** C03C 2201/06; C03C 2201/10; C03C 2201/32; C03C 2201/50; C03C 2201/54; H03H 3/0076; H03H 9/02448; H03H 9/2468

(54) **RÉSONATEUR THERMOCOMPENSÉ COMPRENANT UN VERRE**

**WÄRMEKOMPENSIERTER RESONATOR, DER EIN GLAS UMFASST**

**THERMALLY COMPENSATED RESONATOR COMPRISING A GLASS**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.01.2016 CH 262016**

(43) Date de publication de la demande:
**12.07.2017 Bulletin 2017/28**

(73) Titulaire: **Richemont International SA**
**1752 Villars-sur-Glâne (CH)**

(72) Inventeurs:
• **BEAU, Philippe**
  **25170 Recologne (FR)**
• **CARBILLET, Stani**
  **25660 Saône (FR)**
• **DUFFOURS, Laurent**
  **34000 Montpellier (FR)**
• **ROQUES-CARMES, Claude**
  **25000 Besançon (FR)**
• **STUER, Michael**
  **2000 Neuchâtel (CH)**

(74) Mandataire: **P&TS SA (AG, Ltd.)**
**Avenue J.-J. Rousseau 4**
**P.O. Box 2848**
**2001 Neuchâtel (CH)**

(56) Documents cités:
EP-A1- 1 791 039      EP-A1- 2 590 325
EP-A1- 2 741 149      CH-A- 307 683
DD-A5- 287 934        GB-A- 801 314

• **MOHAMMED KAMEL RABIA ET AL: "A-thermal elastic behavior of silicate glasses", JOURNAL OF PHYSICS: CONDENSED MATTER, INSTITUTE OF PHYSICS PUBLISHING, BRISTOL, GB, vol. 28, no. 7, 27 janvier 2016 (2016-01-27), page 75402, XP020299686, ISSN: 0953-8984, DOI: 10.1088/0953-8984/28/7/075402 [extrait le 2016-01-27]**

**Description**

Domaine technique

La présente invention concerne un résonateur horloger thermocompensé pour pièce d'horlogerie comprenant au moins une portion fabriqué dans un verre. Le résonateur ne nécessite pas l'ajout d'un revêtement ni la réalisation d'un traitement subséquent afin d'obtenir la thermocompensation.

Etat de la technique

La précision des montres mécaniques dépend de la stabilité de la fréquence propre de l'oscillateur, typiquement formé du balancier-spiral. Lorsque la température varie, les dilatations thermiques du spiral et du balancier, ainsi que la variation du module de Young du spiral, modifient la fréquence propre de cet ensemble oscillant, perturbant la précision de la montre.

La plupart des méthodes proposées pour compenser ces variations de fréquence sont basées sur la considération que cette fréquence propre dépend exclusivement du rapport entre la constante du couple de rappel exercé par le spiral sur le balancier et le moment d'inertie de ce dernier, comme indiqué dans la relation suivante:

$$f = \tfrac{1}{2}\,\pi\,(C/I)^{0.5} \qquad\qquad (1),$$

où f est la fréquence propre de l'oscillateur, C est la constante élastique du spiral de l'oscillateur, et I est le moment d'inertie du balancier de l'oscillateur.

La thermocompensation peut être raisonnablement bien décrite pour un système balancier-spiral par la loi semi-empirique suivante:

$$\beta_{spiral} + 3\alpha_{spiral} - 2\alpha_{balancier} = 0 \qquad\qquad (2),$$

où $\beta_{spiral}$ est le coefficient thermique de l'élasticité (autrement dit le coefficient thermoélastique) et $\alpha_i$ les coefficients d'expansion thermique respectivement du spiral et du balancier. Cette équation doit être satisfaite dans une plage de température d'intérêt, par exemple entre 8°C et 38°C, c'est-à-dire dans la plage de températures standards du COSC Par satisfaire, on entend que la variation de marche de l'oscillateur ne dépasse pas 0.6 sec/j/°C. Une solution triviale correspondrait à la mise à 0 de chaque grandeur matière. Cette solution est difficile, voir impossible, à atteindre en réalité, puisque des couples matières dont les grandeurs satisfont l'équation de thermocompensation doivent être parfaitement choisies. Bien que l'équation donnée permette de bien exprimer le genre d'exigences nécessaires pour la thermocompensation, d'autres relations plus affinées et complexes existent pour la même cause.

Le silicium est de plus en plus utilisé pour la fabrication de ressort-spiraux et d'autres types de résonateurs pour les mouvements horlogers. Cependant, le module d'Young du silicium est fortement influencé par la température et une compensation de cet effet est nécessaire pour son utilisation dans des applications horlogères. En effet, le coefficient thermique du module de Young du silicium est de l'ordre de $-60\times10^{-6}$ °C et la dérive thermique d'un ressort spiral en silicium est ainsi d'environ 155 secondes/jour, pour une variation de température de 30°C autour de la température moyenne de 23°C. Cela le rend incompatible avec les exigences de marche diurne d'une montre qui sont de l'ordre de 8 secondes/jour.

Le document EP1422436 divulgue un spiral formé en silicium et recouvert de dioxyde de silicium afin de rendre le coefficient thermique sensiblement nul entre les températures de procédure COSC, c'est-à-dire entre +8°C et +38°C.

Le document EP2590325 décrit un résonateur thermocompensé comportant un corps formé par un verre et comportant un revêtement dont les variations du module d'Young en fonction de la température sont de signe opposé à celles du verre afin de permettre au résonateur d'avoir une variation de fréquence en fonction de la température au moins au premier ordre sensiblement nulle.

Le brevet CH699780 décrit un ressort spiral en silicium, destiné à équiper un oscillateur mécanique balancier-spiral de mouvement d'horlogerie dont, selon une forme d'exécution, la surface extérieure est dopée de manière à compenser au moins partiellement le coefficient thermique du module de Young du silicium. Le dopage est effectué par un procédé de diffusion chimique ou par un procédé d'implantation ionique à l'aide d'un élément non métallique comme le bore, le phosphore, l'azote, le carbone, ou un élément métallique, ou encore une mixture de ces éléments.

Le brevet CH307683 décrit un élément élastique pour appareils chronométriques, caractérisé en ce qu'il comprend un verre dont la teneur en silice est comprise entre 75% et 85%. Le brevet GB 801 314 décrit un élément thermocompensé pour appareils chronométriques comprenant un verre "Pyrex".

Résumé

L'invention concerne le développement de matières au moins partiellement amorphes, et plus particulièrement des verres dont la composition est choisie pour que les propriétés conviennent à son utilisation comme composant horloger d'un organe réglant, tel qu'un résonateur, par exemple, comme ressort spiral dans un mouvement horloger mécanique. Dans de telles utilisations, il est nécessaire que l'expansion thermique du résonateur soit suffisamment faible et que le coefficient thermique d'élasticité du résonateur soit proche de zéro ou idéalement légèrement positif. Ces deux conditions sont nécessaires pour pouvoir répondre aux besoins de thermocompensation de l'organe réglant, sans quoi l'élaboration d'une montre précise devient impossible.

Plus particulièrement, l'invention concerne un composant horloger thermocompensé comprenant au moins une portion fabriqué dans un verre, le verre constitué, en pourcent massique, de 65% à 99% d'un oxyde de silicium, par exemple le $SiO_2$, de 0.01 % à 1.5% d'un oxyde d'aluminium, par exemple $Al_2O_3$, au moins un premier métal alcalin ou un premier métal alcalino-terreux sous forme atomique, ionique ou autre et jusqu'à 0.5% d'un additif comprenant au moins un second métal alcalin ou un second métal alcalino-terreux, différent du premier métal alcalin ou alcalino-terreux.

Selon un autre mode de réalisation, le verre comprend en outre entre 0.01 % et 15% d'un oxyde de bore (tel que $B_2O_3$).

Le composant peut comprendre un résonateur tel qu'un ressort spiral d'un système oscillateur de type balancier-spiral ou tout autre type de résonateur, tel qu'une lame vibrante ou un diapason, pouvant être associé à une inertie séparée. l'invention se rapporte également à une pièce d'horlogerie comprenant un tel composant.

Cette solution présente notamment l'avantage par rapport à l'art antérieur que le verre est caractérisé par une valeur absolue de coefficient thermique de l'élasticité β qui est faible. Il est donc possible de fabriquer à partir de ce verre un résonateur qui est essentiellement thermocompensé. Il n'est pas nécessaire d'ajouter un revêtement qui compense une valeur de β trop élevée du matériau de base ni de réaliser un traitement subséquent sur le matériau de base afin d'obtenir la thermocompensation.

Par "résonateur thermocompensé" on entend un résonateur dont l'expansion thermique est suffisamment faible et dont le coefficient thermique d'élasticité est proche de zéro ou idéalement légèrement positif, de sorte à obtenir une thermocompensation de l'organe réglant.

Exemple(s) de mode de réalisation

Le fait de pouvoir agir de façon contrôlée sur les coefficients d'expansion thermique et d'élasticité thermique constitue un atout non-négligeable dans la quête de réaliser des montres mécaniques de plus en plus précises. Pour chaque matière de balancier choisie, il y a une série de couple $\{\alpha_{spiral};\ \alpha_{balancier};\ \beta_{spiral}\}$ qui permettent d'atteindre la thermocompensation.

L'invention concerne donc un composant horloger thermocompensé comprenant au moins une portion fabriqué dans un verre dont le coefficient thermique d'élongation et d'élasticité est contrôlé, par le biais d'ajouts, couramment appelés dopants ou additifs dans le verre non-métallique.

Le point de base pour la présente invention est le comportement anormal de la silice amorphe, qui dans une plage suffisamment large autour de la température ambiante présente un β largement positif. Ce comportement est dit anormal, car il n'est pas lié à un changement de régime d'une grandeur physique telle que la thermocompensation par effet de magnétostriction pour un spiral de type Elinvar. En effet, en l'absence d'un régime transitoire d'une grandeur physique, chaque matière devrait se ramollir au fur et à mesure qu'on augmente sa température: son β est donc négatif. Ce comportement est d'ailleurs vérifié pour la silice cristalline.

L'origine de cette anomalie est en effet structurelle et liée à la forme tétraédrique de l'unité de base ($SiO_{4/2}$). Les tétraèdres étant reliés entre eux par des oxygènes pontants, ils peuvent tourner autour de ces liaisons, changeant ainsi la conformation du réseau amorphe. Ces changements sont activés thermiquement et entraînent, dans la plage de température où ils interviennent, une rigidification de la structure en augmentant la distance entre les oxygènes de tétraèdres adjacents. Par conséquent, la «souplesse» structurelle du réseau de tétraèdres est graduellement perdue et la rigidification qui en résulte l'emporte sur le ramollissement conventionnel qui intervient en parallèle. La matière apparait macroscopiquement rigidifiée avec une augmentation de la température. Une fois que la perte de souplesse s'atténue ou s'arrête passé la température critique où la contribution structurelle du verre sur son élasticité devient suffisamment faible, le verre aura de nouveau un β négatif. Ce comportement anormal peut-être observé de façon plus générique dans tout type de verre présentant une unité de base tétraédrique et dont chaque liaison peut-être approximée comme équivalente. Par exemple on peut citer en dehors du SiOz les matériaux suivants: les verres d'oxydes (GeOz,...), les verres d'halogénures ($BF_2$,...), les verres de chalcogénures (BeF2, ...), les verres de phosphates ($Zn(PO_3)_2$,...) et certains verres métalliques et organiques. La plage de température d'intérêt sur laquelle intervient ce comportement anormal peut par contre se trouver altérée entre ces différentes natures de verre et selon les additifs choisis.

L'existence ou l'évolution de ce type de changements structurels peut être liée à des mécanismes de frottements internes. Lorsqu'on rajoute principalement des alcalins et/ou des alcalino-terreux, on rajoute et/ou modifie les amplitudes et les énergies auxquels des frottements ont lieu. Les pics de frottements internes se situent généralement à des températures entre -100°C et la $T_g$, la température de transition vitreuse. Plus le réseau percolant de tétraèdres est détruit, ou autrement dit, plus il y a des oxygènes non-pontants, plus il y a des nouveaux pics de pertes intenses. En parallèle on peut observer une décroissance du β jusqu'à devenir négatif. La réduction de β avec la rupture du réseau tétraédrique s'explique par une perte de cette capacité à solliciter la structure / géométrie (angles / rotations) avant de passer graduellement à une sollicitation des liaisons Si-O plus directement.

Les propriétés thermiques (et chimiques) des verres à structures élémentaires tétraédriques sont donc influencées et contrôlées par l'ajout d'éléments qu'on peut qualifier d'additifs ou encore de dopants. Ces éléments modifiant directement les propriétés du verre, il est important et indispensable de connaître l'action de chaque ajout. Parmi les ajouts les plus intéressants on peut citer: des modificateurs de type alcalins et/ou alcalino-terreux, des fondants et des stabilisants de phase ou de réseau. Il est pourtant à noter qu'un élément peut, en fonction des autres éléments présents, présenter une combinaison de ces fonctions.

Les modificateurs de réseau ont pour fonction d'introduire ou de changer le ratio entre oxygènes non-pontants (ONP) et oxygènes pontants (OP), formant une chaine -(Si-O-Si)-. Même si d'autres paramètres entrent en jeu, on peut dire que pour une série et des ratios de modificateurs spécifiés, plus le ratio ONP/(OP+ONP) est élevé plus le β est faible (en partant de valeurs positives vers des valeurs négatives).

L'efficacité des alcalins sur la réduction du β diminue avec leur électropositivité (caractère métallique) croissante. Au lieu de raisonner en termes de force de liaison, on peut aussi raisonner en termes d'encombrement stérique et signaler que leur efficacité diminue avec taille (cationique) croissante. Pour les alcalino-terreux, l'effet sur la réduction du β est plus compliquée. À cause de leur charge 2+, il y a un mélange entre effet stérique, concentration et électropositivité dont les proportions varient selon le taux d'ajout.

Pour des concentrations cationiques équivalentes (p.ex. $Na^+$ et $Ca^{2+}$), les alcalino-terreux ont une efficacité accrue sur la réduction du β. Pour une impureté choisie, et particulièrement pour les alcalins, la réduction du β est linéaire avec la concentration pour autant que le ratio ONP/(OP+ONP) n'est pas trop élevé et en particulier est inférieur à 0.5, ou idéalement inférieur à 0.2. Ces tendances générales s'appliquent particulièrement en l'absence d'effet alcali-mixte. En effet, lorsqu'on rajoute deux alcalins de tailles cationiques différentes, leurs effets sur le β n'est pas additif. À concentrations molaires égales, en particulier, leur effet synergétique est maximal baissant nettement d'avantage le β qu'attendu par une loi de mélange linéaire. En choisissant donc judicieusement les teneurs en alcalins ajoutés à la silice amorphe, il est possible de faire baisser très rapidement le β et ainsi réduire la quantité de modificateurs nécessaires. Ceci est d'autant plus important si on prend en compte l'augmentation de la sensibilité du verre à l'hygrométrie.

Il est à noter qu'on aura tendance à éviter des formulations de verres binaires, et en particulier pour les verres silicates, car elles sont sujettes à des problèmes de démixtion et de cristallisation.

Alors que l'effet des alcalins sur la diminution du béta diminue avec leur taille cationique, rendant les petits cations plus attrayants, les petits cations sont moins attrayants si l'on considère les problèmes liés à des changements stoechiométriques pendant l'élaboration à haute température dues au problème d'évaporation / sublimation de ces petits cations. Il est ainsi plus difficile de travailler avec le lithium et/ou le béryllium (en laissant de côté les enjeux en termes de toxicité), qu'avec le potassium et le sodium par exemple. Néanmoins si les étapes du processus d'élaboration sont bien établies et figées, il est possible de calculer la quantité excédentaire d'alcalins nécessaire pour arriver à la stoechiométrie désirée à la fin de l'élaboration et de la mise en forme des verres. Les petits cations ont aussi tendance à favoriser les phénomènes de cristallisation et de démixtion. On préfère ainsi généralement travailler avec les éléments tels que: Na, K, et Mg car ils permettent d'obtenir un bon compromis entre efficacité sur la réduction du β et reproductibilité des résultats en tenant compte de la précision de stoechiométrie réalisable lors de l'élaboration des verres.

Selon les formulations de verre, les points de fusions sont souvent trop élevés pour pouvoir les réaliser de façon économiquement viable et maitrisée. Pour cette raison en particulier il est opportun de rajouter des éléments qui font baisser la température de fusion. Alors qu'à priori chaque ajout dans la silice peut baisser son point de fusion des éléments comme l'alumine sont particulièrement intéressants, baissant rapidement le point de fusion avec des effets sur le β contrôlables. En effet, selon la formulation de verre l'alumine a tendance à former ou maintenir le réseau tétraédrique intact. Ceci est particulièrement vrai en présence d'alcalins ($X_2O$), lorsque leur concentration molaire est supérieure ou égale à la concentration molaire en $Al^{3+}$. En effet, dans ce cas le maintien de la neutralité des charges locales est assuré par la compensation d'un cation $Al^{3+}$ par un cation ($X^+$) introduit dans le réseau silicaté. Il faut cependant noter que l'ajout d'alumine introduit la notion de concentration effective en alcalins, par opposition à la concentration absolue en terme de création d'oxygènes non-pontants. Ainsi en présence d'alumine, un ajout supplémentaire d'alcalins est nécessaire pour arriver à une réduction du β au même niveau qu'en son absence. À l'inverse, lorsque l'introduction d'alumine dans le réseau silicaté ne peut pas être stabilisé à cause d'une concentration en alcalins insuffisante, l'alumine peut agir en tant que modificateur de réseau introduisant des oxygènes non-pontants.

Un autre effet avantageux de l'alumine est qu'elle a généralement aussi tendance à stabiliser les verres quant aux problèmes de démixtion et de cristallisation. Son introduction dans le réseau silicaté rigidifie localement le réseau permettant à des cations alcalins ou alcalino-terreux d'être accommodés dans la structure avec un excédent énergétique minimal. Elle renforce également la résistance hydrolytique du verre.

Il n'est cependant pas judicieux de faire baisser la température de fusion plus que nécessaire pour l'élaboration des verres. En effet, l'expansion thermique des verres augmente lorsque la température de fusion diminue. L'ajout de $B_2O_3$ est souvent employé car il n'a que peu d'influence sur l'expansion thermique des verres (p.ex. verres Pyrex®). Le $B_2O_3$ adoptant généralement une coordinance 3, il fait aussi baisser le β en introduisant un oxygène non-pontant. Selon la stoechiométrie locale et la température, il peut par contre adopter une configuration tétraédrique similaire à la silice et ainsi agir en tant que formateur de réseau à part égale (i.e. anomalie du bore). L'ajustement de la quantité d'ajouts en alcalins et en alcalino-terreux en présence de bore se réalise donc généralement de façon expérimentale. Ainsi des verres avec des β positifs optimaux pour une application en tant que spiral peuvent être obtenus même avec des concentrations en silice assez faibles pour autant que qualitativement la somme massique de $SiO_2$, $Al_2O_3$ et $B_2O_3$ (i.e. formateur de réseau) est supérieure à 70%. La concentration exacte dépendra de l'efficacité des alcalins et alcalino-terreux à faire baisser le β. Une alternative au $B_2O_3$ est le ZnO. L'ajout de très faibles quantités $Fe_2O_3$ est aussi courant utilisée car il permet de réduire la viscosité du verre très rapidement tout en limitant, de par sa faible concentration, les effets sur le β.

Lors de l'élaboration de verres des difficultés peuvent venir de problèmes de démixtion et de cristallisation. Par exemple, pour un spiral horloger, il est indispensable que la matière se comporte de manière parfaitement homogène à l'échelle d'un spiral horloger. L'apparition/formation de cristaux ou d'hétérogénéités de l'ordre de 10 μm ou plus grand, peut rapidement rendre la matière inutilisable pour une application d'un spiral horloger en compromettant le développement concentrique et les coefficients thermiques locaux.

Selon l'invention, le verre comprend entre 50% et 99% de $SiO_2$, entre 0.01 % et 10% de $Al_2O_3$ mais préférablement entre 0.01% et 1.5% de $Al_2O_3$, jusqu'à 0.5% d'additifs, la balance comprenant au moins un premier métal alcalin, ou un premier métal alcalino-terreux.

Dans la présente divulgation, les pourcentages (%) correspondent à un pourcentage massique. L'expression "métal alcalin" se rapporte à un élément de la première colonne (excepté l'hydrogène) du tableau périodique des éléments et l'expression "métal alcalino-terreux" se rapporte à un élément de la deuxième colonne du tableau périodique des éléments. Le terme "additifs" se rapporte principalement à des métaux alcalins et alcalino-terreux différents qui ceux compris dans la composition principale.

Selon une forme d'exécution, le verre comprend entre 65% et 99% de $SiO_2$.

Selon une variante, le verre comprend au moins un modificateur alcalin (additif). Par exemple, le verre comprend entre 80% et 95% de $SiO_2$, entre 0.01 % et 1 % de $Al_2O_3$ mais préférablement entre 0.01 % et 1.5% de $Al_2O_3$, la balance comprenant du $Na_2O$, et préférablement entre 88% et 91% de $SiO_2$, entre 0.01 % et 1% de $Al_2O_3$, la balance comprenant du $Na_2O$.

Le verre peut également comprendre entre 70% et 80% de $SiO_2$, entre 0.01% et 1% de $Al_2O_3$ mais préférablement entre 0.01% et 1.5% de $Al_2O_3$, et la balance comprenant $K_2O$, et préférablement entre 73% et 79% de $SiO_2$, entre 0.01% et 1% de $Al_2O_3$, et la balance comprenant du $K_2O$.

Selon une autre variante, le verre comprend deux modificateurs alcalins permettant d'obtenir un effet alcali-mixte. Par exemple, le verre peut comprendre entre 90% et 97% de $SiO_2$, entre 0.01% et 1% de $Al_2O_3$ et la balance comprenant du $Na_2O$ et du $K_2O$, dans lequel $Na_2O$ est compris dans une proportion de 10 à 90 parties massiques pour 100 parties massique pour $Na_2O$ et $K_2O$.

Le verre peut également comprendre entre 90% et 97% de $SiO_2$, entre 0.01% et 1% de $Al_2O_3$ et la balance comprenant du $Na_2O$ et un autre alcalin, et préférentiellement le $Rb_2O$, dans lequel $Na_2O$ est compris dans une proportion de 10 à 90 parties massiques pour 100 parties massique pour $Na_2O$ et $Rb_2O$.

Encore selon une autre variante, le verre comprend au moins un modificateur alcalino-terreux. Par exemple, le verre peut comprendre entre 90% et 97% de $SiO_2$ ou entre 90% et 98% de $SiO_2$, entre 0.01 % et 1% de $Al_2O_3$, et la balance comprenant du MgO. Le verre peut également comprendre entre 75% et 90% de $SiO_2$ ou entre 77% et 88% de $SiO_2$, entre 0.01 % et 1 % de $Al_2O_3$ et la balance comprenant du CaO. Préférablement, la proportion de $SiO_2$ peut être entre 88% et 91%.

Selon une autre forme d'exécution, le verre comprend entre 65% et 99% de $SiO_2$, entre 0.01 % et 10% de $Al_2O_3$ mais préférablement entre 0.01 % et 1.5% de $Al_2O_3$, jusqu'à 0.5% d'additifs, entre 0.01 % et 10% d'un oxyde de bore, et la balance comprenant au moins un premier métal alcalin ou un premier métal alcalino-terreux.

Par exemple, le verre peut comprendre entre 80% et 95% de $SiO_2$, entre 0.01 % et 10% de $Al_2O_3$ mais préférablement entre 0.01% et 1.5% de $Al_2O_3$, entre 0.01 % et 10% de $B_2O_3$, et la balance comprenant du $Na_2O$. Préférablement, la proportion de $SiO_2$ peut être entre 80% et 92%.

Dans un autre exemple, le verre peut comprendre entre 70% et 85% de $SiO_2$, entre 0.01 % et 10% de $Al_2O_3$ mais préférablement entre 0.01 % et 1.5% de $Al_2O_3$, entre 0.01 % et 10% de $B_2O_3$, et la balance comprenant du $K_2O$.

Encore dans un autre exemple, le verre peut comprendre entre 85% et 98% de $SiO_2$, entre 0.01 % et 10% de $Al_2O_3$ mais préférablement entre 0.01 % et 1.5% de $Al_2O_3$, entre 0.01 % et 10% de $B_2O_3$, et la balance comprenant du MgO. Préférablement, la proportion de SiOz peut être entre 87% et 98%.

Table 1

| Formulation | $\beta$ ($10^{-6}$ K$^{-1}$) | $\alpha$ ($10^{-6}$ K$^{-1}$) |
|---|---|---|
| 91.5% SiO$_2$, 7.6% Na$_2$O, 0.1% K$_2$O et 0.7% Al$_2$O$_3$ | 90 | 4.1 |
| 84% SiO$_2$, 15.4% Na$_2$O et 0.5% Al$_2$O$_3$ | 106 | 7.4 |
| 81.6% SiO$_2$, 17.5% K$_2$O, 0.1% CaO et 0.7% Al$_2$O$_3$ | 83 | 6.4 |
| 81.5% SiO$_2$, 8.1% Na$_2$O, 9.6% K$_2$O, 0.1% CaO, 0.1 % BaO et 0.7% Al$_2$O$_3$ | 135 | 9.6 |
| 89% SiO$_2$, 10.1% Na$_2$O, 0.1 % K$_2$O, 0.1 % CaO, 0.1 % MgO et 0.7% Al$_2$O$_3$ | 46 | 5.7 |
| 88.9% SiO$_2$, 7.7% Na$_2$O, 0.1% K$_2$O, 0.1% CaO, 2.5% MgO, 0.1 % BaO et 0.7% Al$_2$O$_3$ | 32 | 5 |
| 85.6% SiO$_2$, 8.2% Na$_2$O, 5.4% MgO et 0.7% Al$_2$O$_3$ | -5 | 5.2 |
| 89.8% SiO$_2$, 7.3% Na$_2$O, 0.1% K$_2$O, 2.1% CaO et 0.7% Al$_2$O$_3$ | 91 | 5.1 |
| 86% SiO$_2$, 7.6% Na$_2$O, 0.1% K$_2$O, 5.5% CaO et 0.7% Al$_2$O$_3$ | 14 | 5.6 |
| 87.2% SiO$_2$, 8% Na$_2$O, 0.1% K$_2$0, 3.9% BaO et 0.7% Al$_2$O$_3$ | 99 | 4.8 |
| 85.7% SiO$_2$, 7.8% Na$_2$O, 0.1% K$_2$O, 5.8% BaO et 0.6% Al$_2$O$_3$ | 77 | 5.1 |
| 89.5% SiO$_2$, 1.7% B$_2$O$_3$, 8.1% Na$_2$O, 0.1 % MgO et 0.6% Al$_2$O$_3$ | 51 | 4.7 |
| 85.9% SiO$_2$, 5.8% B$_2$O$_3$, 7.4% Na$_2$O, 0.1 % K$_2$O, 0.1% BaO et 0.7% Al$_2$O$_3$ | 28 | 4.7 |
| 89.6% SiO$_2$, 9.7% K$_2$O, 0.1% CaO et 0.5% Al$_2$O$_3$ | 113 | 3.5 |
| 81.1% SiO$_2$, 5% Na$_2$O, 13.3% BaO et 0.5% Al$_2$O$_3$ | 42 | 5.2 |
| 91.1% SiO$_2$, 5.6% Na$_2$O, 2.6% CaO et 0.5% Al$_2$O$_3$ | 66 | 3.8 |

Encore dans un autre exemple, le verre peut comprendre entre 75% et 90% de SiOz, entre 0.01 % et 10% de Al$_2$O$_3$ mais préférablement entre 0.01 % et 1.5% de Al$_2$O$_3$, entre 0.01 % et 10% de B$_2$O$_3$, et la balance comprenant du CaO. Préférablement, la proportion de SiOz peut être entre 78% et 90%.

Encore dans un autre exemple, le verre peut comprendre entre 65% et 85% de SiOz, entre 0.01 % et 10% de Al$_2$O$_3$ mais préférablement entre 0.01 % et 1.5% de Al$_2$O$_3$, entre 0.01 % et 10% de B$_2$O$_3$, et la balance comprenant du SrO.

Encore dans un autre exemple, le verre peut contenir entre 0.01 % et 1 % de Fe$_2$O$_3$.

La table 1 montre des exemples de formulations de verre avec les valeurs de $\beta$ et $\alpha$ correspondantes. Les valeurs de $\beta$ sont mesurées par méthode vibrationnelle entre 10°C et 40°C à humidité relative constante pour chacune des formulations. Les valeurs $\alpha$ fournies sont indicatives pour l'évolution de ce paramètre à température ambiante et mesurées entre 200°C et 400°C par dilatométrie.

Dans un mode de réalisation, le composant selon l'invention peut être utilisé pour la fabrication d'au moins une portion d'un résonateur thermocompensé destiné à équiper un mouvement d'horlogerie ou autre instrument de précision.

La fabrication du résonateur peut être réalisée par une méthode d'usinage du verre incluant notamment la découpe, un procédé de gravure, par exemple par gravure ionique réactive profonde (en anglais *Deep Reactive Ion Etching DRIE*), un procédé de gravure chimique, une méthode d'usinage tridimensionnelle utilisant un laser, ou toute autre méthode d'usinage appropriée. La fabrication du résonateur peut également être réalisée réalisé par le formage d'une fibre/préforme de verre.

La fabrication peut comporter une étape subséquente de traitement de surface de la structure usinée, par exemple une étape de polissage et/ou d'échange ionique et/ou d'implantation ionique.

Un résonateur thermocompensé fabriqué en totalité ou en partie dans le verre de l'invention peut être avantageusement monté dans un système oscillant d'une pièce d'horlogerie ou tout autre instrument de précision.

**Revendications**

1. Composant horloger thermocompensé comprenant au moins une portion fabriquée dans un verre constitué, en pourcentage massique, de 65% à 99% d'un oxyde de silicium, de 0.01 % à 1.5% d'un oxyde d'aluminium, d'au moins un premier métal alcalin ou un premier métal alcalino-terreux; et jusqu'à 0.5% d'un additif comprenant au moins un second métal alcalin ou un second métal alcalino-terreux, différent du premier métal alcalin ou alcalino-terreux.

2. Le composant horloger thermocompensé selon la revendication 1, constitué de 80% à 95% de $SiO_2$, de 0.01% à 1.5% de $Al_2O_3$, la balance comprenant du $Na_2O$.

3. Le composant horloger thermocompensé selon la revendication 1, constitué de 70% à 80% de $SiO_2$, de 0.01% à 1.5% de $Al_2O_3$, et la balance comprenant du $K_2O$.

4. Le composant horloger thermocompensé selon la revendication 1, constitué de 90% à 97% de $SiO_2$, de 0.01% à 1% de $Al_2O_3$ et la balance comprenant du $Na_2O$ et du $K_2O$, dans lequel $Na_2O$ est compris dans une proportion de 50 à 70 parties massiques pour 100 parties massique pour $Na_2O$ et $K_2O$.

5. Le composant horloger thermocompensé selon la revendication 1, constitué de 90% à 97% de $SiO_2$, de 0.01 % à 1 % de $Al_2O_3$ et la balance comprenant du $Na_2O$ et du RbzO, dans lequel $Na_2O$ est compris dans une proportion de 10 à 90 parties massiques pour 100 parties massique pour $Na_2O$ et RbzO.

6. Le composant horloger thermocompensé selon la revendication 1, constitué de 90% à 98% de $SiO_2$, de 0.01 % à 1 % de $Al_2O_3$, et la balance comprenant du MgO.

7. Le composant horloger thermocompensé selon la revendication 1, constitué de 77% à 88% de $SiO_2$, de 0.01 % à 1 % de $Al_2O_3$, la balance comprenant du CaO.

8. Composant horloger thermocompensé comprenant au moins une portion fabriquée dans un verre constitué, en pourcentage massique, de 65% à 99% d'un oxyde de silicium, de 0.01% à 1.5% de $Al_2O_3$, jusqu'à 0.5% d'un additif comprenant au moins un second métal alcalin ou un second métal alcalino-terreux, entre 0.01 % et 15% d'un oxyde de bore et au moins un premier métal alcalin ou un premier métal alcalino-terreux.

9. Le composant horloger thermocompensé selon la revendication 8, constitué de 80% à 92% de $SiO_2$, de 0.01 % à 1.5% de $Al_2O_3$, de 0.01 % à 10% de $B_2O_3$, et la balance comprenant du $Na_2O$.

10. Le composant horloger thermocompensé selon la revendication 8, constitué de 70% à 85% de SiOz, de 0.01 % à 1.5% de $Al_2O_3$, de 0.01 % à 10% de $B_2O_3$, et la balance comprenant du $K_2O$.

11. Le composant horloger thermocompensé selon la revendication 8, constitué de 87% à 98% de $SiO_2$, de 0.01 % à 1.5% de $Al_2O_3$, de 0.01 % à 10% de $B_2O_3$, et la balance comprenant du MgO.

12. Le composant horloger thermocompensé selon la revendication 8, constitué de 78% à 90% de $SiO_2$, de 0.01 % à 1.5% de $Al_2O_3$, de 0.01 % à 10% de $B_2O_3$, et la balance comprenant du CaO.

13. Le composant horloger thermocompensé selon la revendication 8, constitué de 65% à 85% de $SiO_2$, de 0.01 % à 1.5% de $Al_2O_3$, de 0.01 % à 10% de $B_2O_3$, et la balance comprenant du SrO.

14. Le composant horloger thermocompensé selon l'une des revendications 1 à 13 comprenant un résonateur comprenant un ressort spiral d'un système oscillateur de type balancier-spiral, une lame vibrante ou un diapason.

15. Pièce d'horlogerie comprenant le composant horloger thermocompensé selon l'une des revendications 1 à 14.

**Patentansprüche**

1. Thermokompensierte Uhrenkomponente mit mindestens einem Teil, welches aus einem Glas hergestellt ist, das in Gewichtsprozent aus 65% bis 99% Siliziumoxid, 0,01% bis 1,5% Aluminiumoxid, mindestens einem ersten Alkalimetall oder einem ersten Erdalkalimetall und bis zu 0,5% eines Zusatzstoffes besteht, das mindestens ein zweites Alkalimetall oder ein zweites Erdalkalimetall umfasst, das sich von dem ersten Alkalimetall oder Erdalkalimetall unterscheidet.

**2.** Die thermokompensierte Uhrenkomponente nach Anspruch 1, bestehend aus 80% bis 95% SiOz, 0.01 % bis 1.5% $Al_2O_3$ , wobei die restmenge $Na_2O$ umfasst.

**3.** Die thermokompensierte Uhrenkomponente nach Anspruch 1, bestehend aus 70% bis 80% SiOz, 0.01% bis 1.5% $Al_2O_3$, und die Restmenge umfasst $K_2O$.

**4.** Die thermokompensierte Uhrenkomponente nach Anspruch 1, bestehend aus 90% bis 97% SiOz, 0,01% bis 1% $Al_2O_3$ und die Restmenge $Na_2O$ und $K_2O$ umfasst, wobei $Na_2O$ in einem Verhältnis von 50 bis 70 Gewichtsanteilen pro 100 Gewichtsanteilen für $Na_2O$ und $K_2O$ enthalten ist.

**5.** Die thermokompensierte Uhrenkomponente nach Anspruch 1, bestehend aus 90% bis 97% SiOz, 0.01% bis 1% $Al_2O_3$ und die Restmenge $Na_2O$ und $Rb_2O$ umfasst, wobei $Na_2O$ in einem Verhältnis von 10 bis 90 Gewichtsanteilen pro 100 Gewichtsanteilen für $Na_2O$ und $Rb_2O$ enthalten ist.

**6.** Die thermokompensierte Uhrenkomponente nach Anspruch 1, bestehend aus 90% bis 98% SiOz, 0.01 % bis 1% $Al_2O_3$ , und die Restmenge MgO umfasst.

**7.** Die thermokompensierte Uhrenkomponente nach Anspruch 1, bestehend aus 77% bis 88% SiOz, 0.01% bis 1% $Al_2O_3$ , wobei die Restmenge CaO umfasst.

**8.** Thermokompensierte Uhrenkomponente, die mindestens einen Teil umfasst, welches aus einem Glas hergestellt ist, das in Gewichtsprozent aus,
65% bis 99% eines Siliziumoxids, 0,01% bis 1,5% $Al_2O_3$, bis zu 0,5% eines Zusatzstoffes, das mindestens ein zweites Alkalimetall oder ein zweites Erdalkalimetall, zwischen 0,01% und 15% eines Boroxids und mindestens ein erstes Alkalimetall oder ein erstes Erdalkalimetall umfasst.

**9.** Die thermokompensierte Uhrenkomponente nach Anspruch 8, bestehend aus 80% bis 92% SiOz, 0.01 % bis 1.5% $Al_2O_3$ , 0.01 % bis 10% $B_2O_3$, und die Restmenge $Na_2O$ umfasst.

**10.** Die thermokompensierte Uhrenkomponente nach Anspruch 8, bestehend aus 70% bis 85% SiOz, 0.01% bis 1.5% $Al_2O_3$ , 0.01 % bis 10% $B_2O_3$, und die Restmenge $K_2O$ umfasst.

**11.** Die thermokompensierte Uhrenkomponente nach Anspruch 8, bestehend aus 87% bis 98% SiOz, 0.01 % bis 1.5% $Al_2O_3$ , 0.01 % bis 10% $B_2O_3$, und wobei die Restmenge MgO umfasst.

**12.** Die thermokompensierte Uhrenkomponente nach Anspruch 8, bestehend aus 78% bis 90% SiOz, 0.01 % bis 1.5% $Al_2O_3$ , 0.01 % bis 10% $B_2O_3$, und die Restmenge CaO umfasst.

**13.** Die thermokompensierte Uhrenkomponente nach Anspruch 8, bestehend aus 65% bis 85% SiOz, 0.01 % bis 1.5% $Al_2O_3$ , 0.01 % bis 10% $B_2O_3$, und die Restmenge SrO umfasst.

**14.** Die thermokompensierte Uhrenkomponente nach einem der Ansprüche 1 bis 13 umfassend einen Resonator, der eine Spiralfeder eines Oszillatorsystems der Art Unruh-Spiralfeder, eine schwingende Lamelle oder eine Stimmgabel umfasst.

**15.** Uhr, die das thermokompensierte Uhrenbauteil nach einem der Ansprüche 1 bis 14 umfasst.

**Claims**

**1.** A temperature-compensated timepiece component having at least a portion fabricated from a glass consisting of, by weight percent from 65% to 99% of a silicon oxide; from 0.01 % to 1.5% of an aluminum oxide; at least one first alkali metal or alkaline earth metal; and up to 0.5% of an additive comprising at least one second alkali metal or alkaline earth metal, different from the first alkali metal or alkaline earth metal.

2. The temperature-compensated timepiece component of claim 1,
   consisting of 80% to 95% $SiO_2$, 0.01 % to 1.5% $Al_2O_3$, the remainder comprising NazO.

3. The thermo-compensated timepiece component of claim 1, consisting of 70% to 80% SiOz, 0.01 % to 1.5% $Al_2O_3$, and the remainder comprising $K_2O$.

4. The temperature-compensated timepiece component of claim 1,
   consisting of 90% to 97% $SiO_2$, 0.01% to 1% $Al_2O_3$ and the remainder comprising $Na_2O$ and $K_2O$, wherein $Na_2O$ is in a proportion of 50 to 70 parts by weight per 100 parts by weight of $Na_2O$ and $K_2O$.

5. The temperature-compensated timepiece component of claim 1,
   consisting of 90% to 97% $SiO_2$, 0.01 % to 1% $Al_2O_3$ and the remainder comprising $Na_2O$ and $Rb_2O$, wherein $Na_2O$ is in a proportion of 10 to 90 parts by weight per 100 parts by weight of $Na_2O$ and $Rb_2O$.

6. The temperature-compensated timepiece component of claim 1,
   consisting of 90% to 98% $SiO_2$, 0.01 % to 1% $Al_2O_3$, and the remainder comprising MgO.

7. The temperature-compensated timepiece component of claim 1,
   consisting of 77% to 88% SiOz, % to 1% $Al_2O_3$, the remainder comprising CaO.

8. A temperature-compensated timepiece component comprising at least one portion made of a glass consisting of, by weight percent from 65% to 99% of a silicon oxide, from % to 1.5% of $Al_2O_3$, up to 0.5% of an additive comprising at least a second alkali metal or a second alkaline earth metal, between % and 15% of a boron oxide and at least a first alkali metal or a first alkaline earth metal.

9. The temperature-compensated timepiece component of claim 8,
   consisting of 80% to 92% $SiO_2$, 0.01 % to 1.5% $Al_2O_3$, 0.01 % to 10% $B_2O_3$, and the remainder comprising $Na_2O$.

10. The temperature-compensated timepiece component of claim 8,
    consisting of 70% to 85% $SiO_2$, 0.01% to 1.5% $Al_2O_3$, 0.01% to 10% $B_2O_3$, and the remainder comprising $K_2O$.

11. The temperature-compensated timepiece component of claim 8,
    consisting of 87% to 98% $SiO_2$, 0.01% to 1.5% $Al_2O_3$, 0.01% to 10% $B_2O_3$, and the remainder comprising MgO.

12. The temperature-compensated timepiece component of claim 8,
    consisting of 78% to 90% $SiO_2$, 0.01 % to 1.5% $Al_2O_3$, 0.01 % to 10% $B_2O_3$, and the remainder comprising CaO.

13. The temperature-compensated timepiece component of claim 8,
    consisting of 65% to 85% $SiO_2$, 0.01% to 1.5% $Al_2O_3$, 0.01% to 10% $B_2O_3$, and the remainder comprising SrO.

14. The temperature-compensated timepiece component according to any of claims 1 to 13 comprising a resonator comprising a balance spring of a balance-spring type oscillator system, a vibrating plate or a tuning fork.

15. A timepiece comprising the temperature-compensated timepiece component of any of claims 1 to 14.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1422436 A
- EP 2590325 A
- CH 699780
- CH 307683
- GB 801314 A